(19) Europäisches Patentamt / European Patent Office / Office européen des brevets

(11) **EP 3 772 821 B1**

(12) **EUROPEAN PATENT SPECIFICATION**

(45) Date of publication and mention
of the grant of the patent:
**10.12.2025 Bulletin 2025/50**

(51) International Patent Classification (IPC):
**H03K 3/015** (2006.01)     **H03K 7/08** (2006.01)

(52) Cooperative Patent Classification (CPC):
**H03K 7/08; H03K 3/015**

(21) Application number: **19190560.3**

(22) Date of filing: **07.08.2019**

(54) **AN ELECTRIC CIRCUIT, A METHOD FOR GENERATING A PULSE WIDTH MODULATED OUTPUT SIGNAL, AND A CONTROL SYSTEM FOR A TIME-OF-FLIGHT CAMERA**

ELEKTRISCHE SCHALTUNG, VERFAHREN ZUR ERZEUGUNG EINES IMPULSBREITENMODULIERTEN AUSGANGSSIGNALS UND STEUERUNGSSYSTEM FÜR EINE FLUGZEITKAMERA

CIRCUIT ÉLECTRIQUE, PROCÉDÉ POUR GÉNÉRER UN SIGNAL DE SORTIE À MODULATION DE LARGEUR D'IMPULSION ET SYSTÈME DE COMMANDE POUR CAMÉRA À TEMPS DE VOL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.02.2021 Bulletin 2021/06**

(73) Proprietor: **Infineon Technologies AG**
**85579 Neubiberg (DE)**

(72) Inventors:
• **Landauer, Gerhard Martin**
**8020 Graz (AT)**
• **Gansinger, Stefan**
**8052 Graz (AT)**

(74) Representative: **2SPL Patentanwälte PartG mbB**
**Landaubogen 3**
**81373 München (DE)**

(56) References cited:
**EP-A2- 2 503 847          GB-A- 1 161 311**
**US-A- 5 130 582          US-A1- 2009 115 535**
**US-A1- 2017 302 170**

EP 3 772 821 B1

## EP 3 772 821 B1

### Description

### Field

Examples relate to an electric circuit, a method for generating a pulse width modulated output signal, and to a control system for a time-of-flight camera, more particularly, examples relate to a concept for reducing an influence of a power supply signal of an electric circuit on a pulse width modulated output signal generated by the electric circuit.

### Background

Integrated circuits may operate based on pulse width modulated signals, such as square wave signals, with a configurable pulse width. For example, an integrated circuit may control an illumination brightness of a light source for time-of-flight (TOF) measurements using a relation between the pulse width of the square wave signal and the illumination brightness. Regarding conventional electric circuits for generating the pulse width modulated signals, the pulse width depends on a power supply signal powering the electric circuit. Thus, for example, the illumination brightness of the light source may vary in response to a varying power supply signal which, for example, may cause unintended effects with respect to applications for time-of-flight measurements.

Document US 2017/302170 A1 refers to a power supply for a smooth power output level transitioning. A basic idea of the power supply is to control a semiconductor switch using a driving waveform toggling between PWM periods of a first and a second type for pulse-width modulation switching. Further, the power supply comprises an energy storage for filtering and storing energy pulses flowing through the semiconductor switch.

Document US 2009/115535 A1 relates to a pules with modulation (PWM) control circuit including a PWM control signal generator for generating a PWM period signal and a PWM resolution signal, the PWM period signal defining a period and the PWM resolution signal defining a resolution of a PWM signal. Further, the PWM control circuit includes a PWM unit for generating the PWM signal based on the PWM period signal and the PWM resolution signal. Further, the PWM control circuit is configured to change a resolution of in one period of the PWM period signal while keeping a frequency of the PWM period signal unchanged.

Document US 5 130 582 A relates to a delay circuit for delaying a digital input signal. The delay circuit has a ramp generator and logic circuit which provides a delayed output when the ramp voltage reaches a threshold voltage. The delay circuit further has a bias circuit which provides bias voltage to the ramp generator so that the delayed output is free from temperature variation, power supply voltage variation and process variation of semiconductor elements.

### Summary

Hence there is a demand for an improved concept for reducing an influence of a power supply on a pulse width modulated output signal generated by an electric circuit.

The invention is defined by the subject matter of the appended claims.

The present invention relates to an electric circuit configured to generate a pulse width modulated output signal. The electric circuit comprises at least one power supply signal input. The electric circuit further comprises a first circuitry configured to generate and output an intermediate signal based on the power supply input signal. The electric circuit further comprises a second circuitry configured to generate the pulse width modulated output signal based on the intermediate signal. The second circuitry comprises an energy storage element and a charging/discharging circuitry configured to discharge and charge the energy storage element using the intermediate signal to modify an energy state of the energy storage element. The second circuitry is configured to generate the pulse width modulated output signal based on the state of the energy storage element. The pulse width modulated output signal is a binary signal changing amplitudes between a high level and a low level. The second circuitry is configured to change a level of the pulse width modulated output signal in response to a condition defined for the energy state of the energy storage element changing from being unfulfilled to being fulfilled. The condition is defined so as to be fulfilled based on a comparison between the energy state of the energy storage element and a threshold value. The second circuitry is configured to vary the threshold value as a function of the power supply signal.

The power supply signal is a voltage signal and the intermediate signal is indicative of a current signal generated by applying at least a fraction of the voltage signal to an adjustable resistor of the first circuitry. The electric circuit further comprises a cascode current mirror. The cascode current mirror is configured to use the current signal as reference current, and to copy and output the reference current to the second circuitry.

Another example relates to a control system for a time-of-flight camera. The control system comprises an electric circuit, as described herein, for generating a pulse width modulated output signal. The control system further comprises a light source for generating a pulsed light signal depending on the pulse width modulated output signal.

A further aspect of the present invention relates to a method for generating a pulse width modulated output signal based on at least one power supply signal input. The method comprises generating, by first circuitry, an intermediate signal based on the power supply signal. The method further comprises charging and discharging, by charging/discharging circuitry of second circuitry', an energy storage element of the second circuitry using the intermediate signal to modify a state of the energy storage element. Additionally, the method comprises generating, by the second circuitry, the pulse width modulated output signal based on the state of the energy storage element. The pulse width modulated output signal is a binary signal changing amplitudes between a high level and a low level. The method further comprises changing, by the second circuitry, a level of the pulse width modulated output signal in response to a condition defined for the energy state of the energy storage element being fulfilled, wherein the condition is defined so as to be fulfilled based on a comparison between the energy state of the energy storage element and a threshold value varying as a function of the power supply signal. The power supply signal is a voltage signal and the intermediate signal is indicative of a current signal generated by applying at least a fraction of the voltage signal to an adjustable resistor of the first circuitry. The current signal is used as reference current for a cascode current mirror. The cascode current mirror copies and outputs the reference current to the second circuitry.

**Brief description of the Figures**

Some examples of apparatuses and/or methods will be described in the following by way of example only, and with reference to the accompanying figures, in which

Fig. 1 schematically illustrates an example of an electric circuit for generating a pulse width modulated output signal not according to the claimed subject matter;

Fig. 2 illustrates a first example of the electric circuit not according to the claimed subject matter;

Fig. 3 illustrates a diagram indicating a temporal progress of signals processed by the electric circuit in an example;

Fig. 4 illustrates a second example of the electric circuit not according to the claimed subject matter;

Fig. 5a illustrates a third example of the electric circuit with a cascode current mirror in accordance with the claimed subject matter;

Fig. 5b illustrates the third example of the electric circuit with a cascode current mirror biased by a cascode voltage in accordance with the claimed subject matter;

Fig. 6 illustrates a fourth example comprising an inductor for generating the pulse width modulated output signal not according to the claimed subject matter;

Fig. 7 shows a flow chart schematically depicting an example of a method for generating the pulse width modulated output signal.

**Detailed Description**

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described.

It will be understood that when an element is referred to as being "connected" or "coupled" to another element, the elements may be directly connected or coupled via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

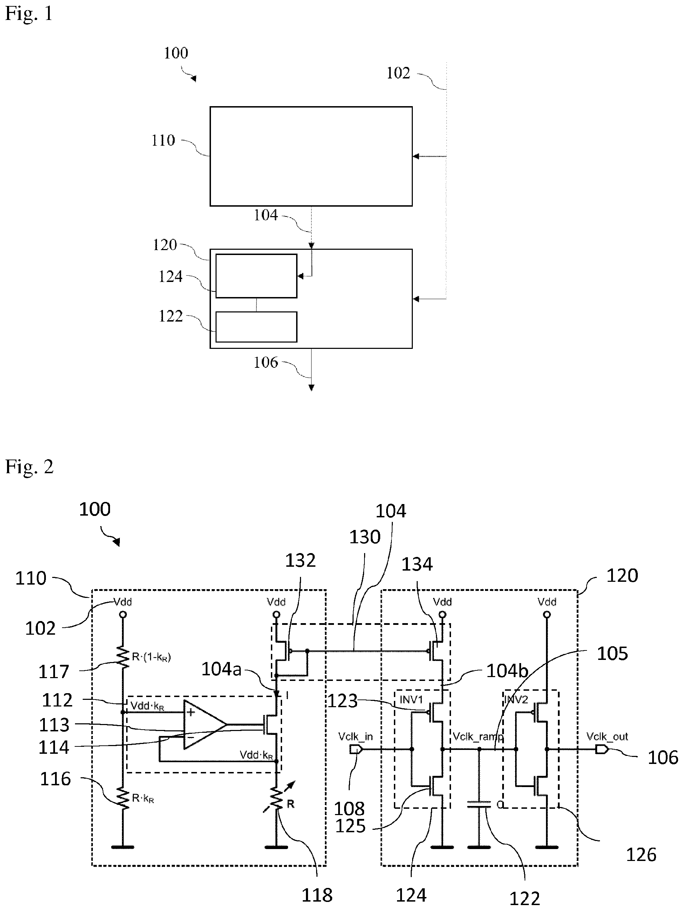

Fig. 1 schematically illustrates an electric circuit 100 for generating a pulse width modulated output signal 106. The electric circuit 100 is supplied by a power supply signal 102 which may be input into a first circuitry 110 and into a second circuitry 120 comprised by the electric circuit 100. The first circuitry 110 is configured to generate an intermediate signal 104 based on the power supply signal 102 and to output the intermediate signal 104 to the second circuitry 120. For example, a current signal generated within the first circuitry 110 is copied to the second circuitry 120 using the intermediate signal 104. As will be laid out in greater detail below, the intermediate signal 104 may be, for example, a signal, e.g. a voltage signal, conveyed between an input and an output of a current mirror, wherein the input is comprised by the first circuitry 110 and the output is comprised by the second circuitry 120. The intermediate signal 104 is provided to the second circuitry 120 (indicated by the dashed arrow in Fig. 1). The second circuitry 120 is configured to generate the pulse width modulated output signal 106 based on the energy state of the energy storage element 122.

The second circuitry 120 comprises an energy storage element 122 and a charging/discharging circuitry 124 for charging the energy storage element 122 using the intermediate signal 104 and discharging the energy storage element 122, to thereby modify an energy state of the energy storage element 122 which is indicative of an amount of energy stored in the energy storage element 122. To this end, the charging/discharging circuitry 124, for example, is coupled to the energy storage element 122 to control a forwarding of the intermediate signal 104 to the energy storage element 122 as will be laid out in greater detail subsequently.

The desired pulse width modulated output signal 106 provided by the second circuitry 120 may be, for example, a binary signal changing amplitudes between a high level and a low level. The second circuitry 120 may cause the pulse width modulated output signal 106 to change between the high and the low level, i.e. shift from a first level of the low and high levels to the second level of the low and high levels, in response to a condition defined for the energy state of the energy storage element 122 changing from being unfulfilled to being fulfilled. For example, the condition may be specified by a threshold value which varies as function of the power supply signal 102. Thus, the condition may be defined to be fulfilled or unfulfilled based on a comparison between the energy state of the energy storage element 122 and the threshold value.

The intermediate signal 104 and the condition defined for the energy state of the energy storage element 122 both are linked to the power supply signal 102. For example, an amplitude of the intermediate signal 104 increases in response to an amplitude of the power supply signal 102 increasing. At the same time, the condition defined for the energy state of the energy storage element 122 may be modified in response to the increasing amplitude of the power supply signal 102 to at least partly compensate for the influence of the increased intermediate signal 104. This, for example, may cause the condition to become fulfilled for an increased amount of energy stored in the energy storage element 122. In other words, to become fulfilled, the condition requires that a greater amount of energy be stored in the energy storage element 122 compared to what was required prior to the increase of amplitude of the power supply signal 102.

In examples, influences of the intermediate signal 104 and the condition on the pulse width modulated signal 106 in response to the power supply signal at least partly compensate each other. Hence, an overall influence of the power supply signal 102 on the pulse width modulated output signal 106 is reduced.

In the example illustrated in Fig. 2, the power supply signal 102 is a voltage signal $V_{dd}$. At least a portion or fraction $V_{dd}k_R$ of the voltage signal $V_{dd}$ 102 is be applied to an adjustable resistor 118 for generating a current signal 104a using a linear relationship between the voltage signal 102 and the current signal 104a. The adjustable resistor 118, for example, is a binary-weighted ladder or a potentiometer. The intermediate signal 104 is indicative of the current signal 104a in this example. In other words, the intermediate signal 104 is representative of the information contained in the current signal 104a. Based on the intermediate signal 104, the current signal 104a from the first circuitry 110 is copied to obtain a copied current signal 104b at the second circuitry 120.

For providing the portion $V_{dd}k_R$ of the voltage signal $V_{dd}$ 102 to the adjustable resistor 118, the first circuitry 110 may comprise a voltage divider with a first resistor 116 and a second resistor 117 arranged in series. Thus, the portion $V_{dd}k_R$ of the voltage signal $V_{dd}$ 102 at the intermediate node between the first and second resistors 116, 117 may be determined by a ratio between the first resistor 116 ($R(1-k_R)$) and the second resistor 117 ($R\,k_R$), with $R$ being an appropriate reference resistance.

The voltage divider is for instance connected to, e.g. followed by, a control loop 112 for copying/stabilizing the portion $V_{dd}k_R$ and thereby providing the portion $V_{dd}k_R$ to the adjustable resistor 118. To this end, the control loop 112 may comprise an operational amplifier 113 and a transistor 114.

As can be seen in Fig. 2, the transistor 114 may be an n-channel metal-oxide-semiconductor field-effect transistor (NMOS). The skilled person is aware that the transistor 114 alternatively may be a p-channel metal-oxide-semiconductor field-effect transistor (PMOS) or may be of another type of transistor, such as a bipolar transistor.

The control loop 112 may moreover serve as a buffer amplifier (operational amplifier as impedance converter) preventing the voltage divider from being affected by the subsequent signal processing of the first circuitry 110.

The electric circuit 100 is configured to copy the current signal 104a to the second circuitry 120 using a current mirror 130 which electrically connects the first circuitry 110 and the second circuitry 120 together. To this end, the current mirror 130 is configured to use the current signal 104a as reference current in this example. The current mirror 130 is further configured to copy and output the copied current signal 104b to/at the second circuitry 120 for charging the energy storage element 122. As shown in Fig. 2, the energy storage element 122 is a capacitor in this example.

As shown in Fig. 2 the current mirror may comprise a plurality of transistors. In this example, the current mirror 130 comprises a first transistor 132 and a second transistor 134, whose respective gates are connected to each other. This connection also couples the first circuitry 110 and the second circuitry 120 via the intermediate signal 104. In the example illustrated in Fig. 2, those transistors 132 and 134 are p-channel metal-oxide-semiconductor field-effect transistors (PMOS). In further examples the transistors 132 and 134 may be n-channel metal-oxide-semiconductor field-effect transistors (NMOS) or of another type of transistors, such as bipolar transistors.

The capacitor 122 (the energy storage element 122 in general, the following description being made in a non-limiting manner for a capacitor 122) may be charged or discharged by using the charging/discharging circuitry 124. As can be seen in Fig. 2, the charging/discharging circuitry 124 may comprise an inverter with a PMOS 123 and an NMOS 125. Alternatively, the charging/discharging circuitry 124 may be a relay.

The charging/discharging circuitry 124 may be configured to assume two different states for generating the pulse width modulated output signal 106. Depending on its state the charging/discharging circuitry 124 either charges the capacitor 122 with the copied current signal 104b or grounds the capacitor 122 for discharging it. Consequently, a voltage 105 across the capacitor 122 changes. The skilled person having benefit from the present disclosure will appreciate that the voltage 105 is indicative of the energy state of the capacitor 122 according to its fundamental technical principles.

In order to control charging and discharging the capacitor 122, the state of the charging/discharging circuitry 124 is controlled by using a clock signal 108 such that an amplitude of the clock signal 108 defines whether to charge or discharge the capacitor 122. For example, the capacitor 122 may alternately be charged and discharged using a square wave signal as clock signal 108.

In some examples, using the PMOS 123 may lead to an undesirable effect. For example, switching on the PMOS 123 using the clock signal 108 may lead to an undesired jump of the voltage 105 of the capacitor 122 due to an undesired discharge of a parasitic capacitance of the PMOS 134. Hence, alternatively the PMOS 134 may be coupled "directly" to the capacitor 122 and the NMOS 125 without using the PMOS 123.

The second circuitry 120 is configured to assess whether the condition defined for the voltage 105 (the energy state of the element 122 in general) is fulfilled or unfulfilled. In the example of Fig. 2, the second circuitry 120 is thus configured to compare the voltage 105 with the threshold value, for example, by using a voltage comparator circuitry 126. The voltage comparator 126, for example, is an inverter (e.g. a complementary metal-oxide-semiconductor (CMOS) circuit). As can be seen in Fig. 2, the inverter 126, for example, comprises two complementary MOSFETS which both may switch their state if the voltage 105 crosses a threshold value. Due to the arrangement of the MOSFETS they have a common threshold value. Owing to the basic principle of the CMOS, the MOSFETS may perpetually have different states. Thus, the inverter 126 may be implemented as a voltage comparator switching between two states based on a comparison between the voltage 105 and the threshold value.

Alternatively, in some examples, the voltage comparator circuitry 126 may be configured to compare the voltage 105 to the threshold value using an operational amplifier in comparator configuration.

Depending on whether the voltage 105 fulfills the condition (e.g. by exceeding or falling short of the threshold value) defined for the voltage 105, the voltage comparator 126 may switch an output terminal for outputting the pulse width modulated output signal 106 between the voltage signal 102 and ground. Thus, the voltage comparator 126 alternates the pulse width modulated output signal 106 between its two states.

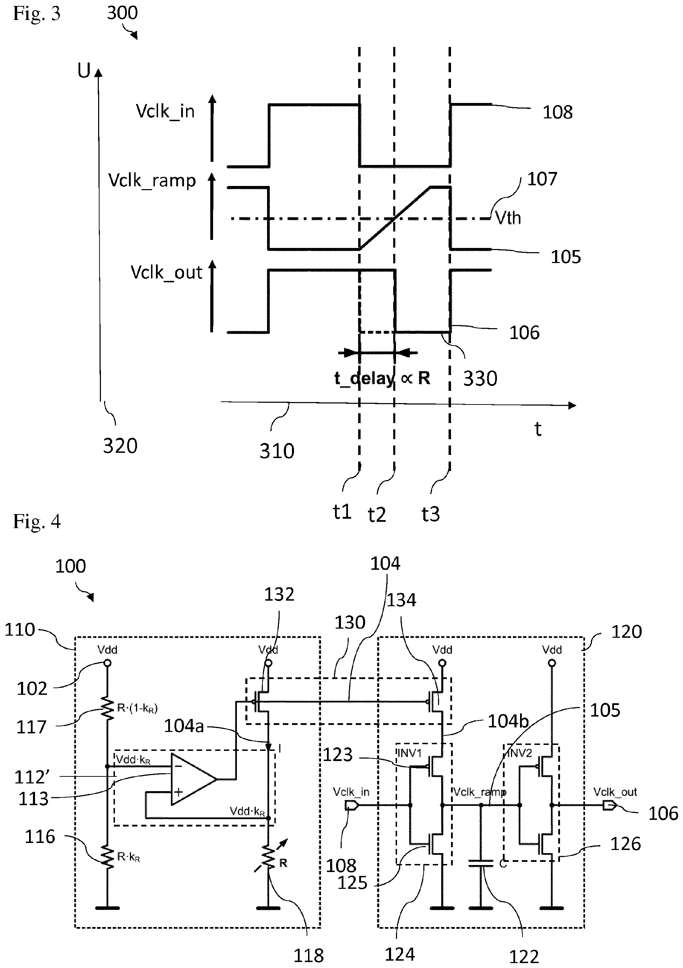

Generating the pulse width modulated output signal 106 is now described in more detail in connection with a diagram 300 in Fig. 3. Diagram 300 describes a temporal progress of the pulse width modulated output signal 106 and the voltage 105 in connection with a temporal progress of the clock signal 108.

A horizontal axis 310 of the diagram 300 refers to time t and the vertical axis 320 refers to voltage U. It should be noted that the diagram 300 merely serves as a qualitative description of signals described herein, as an amplitude and offsets of the signals 106 (Vclk_out), 107 (Vclk_ramp) and 108 (Vclk_in) and the voltage 105 are determined arbitrarily. However, in reality they may have different amplitudes and/or offsets to each other, which is indicated in Fig. 3 by the three smaller vertical axes (showing Vclk_in, Vclk_ramp, and Vclk_out).

At a time t1, when an amplitude of the clock signal 108 drops, the charging/discharging circuitry 124 forwards the copied current signal 104b to the capacitor 122 such that the voltage 105 across the capacitor increases according to

$$Q = C \cdot V_C = I \cdot t, \qquad\qquad (1)$$

wherein $Q$ refers to a charge, $C$ to a capacitance and $V_C$ to the voltage 105 of the capacitor 122. According to (1), the voltage $V_C$ 105 of the capacitor 122 may only depend on the copied current signal $I$ 104b and a charging period t as the capacitance is assumed to be constant for this example. However, in some further examples the capacitance $C$ may be configurable, as will be laid out in more detail later.

The current signal I 104a may depend on the portion $V_{dd}k_R$ of the voltage signal $V_{dd}$ 102 according to

$$I = \frac{V_{dd}k_R}{R}, \qquad\qquad (2)$$

wherein R refers to a resistance of the adjustable resistor 118.

As shown in Fig. 3, an amplitude of the pulse width modulated output signal 106 is on the high level at t1.

At time t2, due to charging the capacitor with the copied current signal 104b (not illustrated in Fig. 3) the voltage $V_C$ 105 exceeds a threshold value $V_{th}$ 107, which may be indicative of a voltage. Consequently, the voltage comparator 126 may ground an output terminal of the second circuitry 120 in order to change the amplitude of the pulse width modulated output signal 106 at time t2 from the high level to the low level. Due to the arrangement of the second CMOS (inverter 126), as shown in Fig. 2, the threshold value $V_{th}$ 107 may be proportional to the voltage signal $V_{dd}$ 102 according to

$$V_{th} \approx \frac{V_{dd}}{2}. \qquad\qquad (3)$$

Due to the arrangement of the MOSFETS of the inverter 126, the threshold value is not dependent of a temperature of the inverter 126 or at least is less influenced by the temperature compared to further voltage comparators known by the skilled person. Thus, the electric circuit 100, for example, is suitable for outdoor applications.

At time t3, the charging/discharging circuitry 124 grounds the capacitor 122 such that the voltage 105 across the capacitor 122 drops below the threshold value $V_{th}$. As the voltage 105 falls short of the threshold value, the output terminal may be connected to the voltage signal 102 for changing the pulse width modulated output signal 106 from the low level to the high level.

Thus, the electric circuit 100 generates a binary pulse width modulated output signal 106 by iterating this procedure from t1 to t3.

Assuming that the voltage $V_C$ 105 is equal to the threshold value $V_{th}$ 107 ($V_{th} = V_C$) at time t2 and with respect to (1), (2) and (3), a delay time $t_d$ indicative of a time period between time t1 and t2 is determined according to

$$t_d = \frac{R \cdot C}{2k_R}, \qquad\qquad (4)$$

wherein $k_R$ refers to a ratio between a resistance of the first and the second resistor 116 and 117 which may be constant in the examples described herein.

In further examples, the first and the second resistor 116 and 117 may be configured to vary $k_R$ to adjust the delay time $t_d$.

Both the copied current signal 104b (based on the intermediate signal 104) and the threshold value, which specifies the condition for the energy state, are linked to the voltage signal/power supply signal 102. For example, according to (3) the second circuitry 120 is advantageously configured to modify the threshold value (the condition regarding the energy state of element 122 in general) in response to the amplitude of the increasing voltage signal/power supply signal 102 to cause the condition to become fulfilled for an increased amplitude of the voltage 105 across the capacitor 122 (for an increased amount of energy stored in element 122 in general).

Further, the copied current signal 104b for charging the capacitor 122 increases in response to the amplitude of the voltage signal 102 increasing. Hence, the influences of the copied current signal 104b and the threshold value $V_{th}$ 107 on the pulse width modulated output signal 106 caused by varying the voltage signal 102 may compensate each other at least partly, in some example even completely.

Thus, theoretically, under ideal circumstances (e.g. constant temperature, no dissipative losses, etc.) and in accordance with (4), the delay time $t_d$ is independent of the amplitude of the voltage signal 102.

In some cases, influences of the copied current signal 104b and the threshold value $V_{th}$ 107 on the pulse width modulated output signal 106 caused by varying the voltage signal 102 may not compensate each other completely but at least partly.

As can be seen in Fig. 3, the delay time $t_d$ and the pulse width are related to each other. Thus, the skilled person having benefit from the present disclosure will appreciate that according to (4) the electric circuit 100 varies the pulse width of the pulse width modulated output signal 106 as a function of an adjustable resistance 118 using a linear relationship between the adjustable resistance 118 and the pulse width.

In some examples, a constant step size in changing the pulse width is desired when changing $t_d$. Due to the inverse relation $t_d \propto 1/I$, a change of the charge current I with constant step size (e.g. with a binary-weighted current mirror) would lead to a change of $t_d$ with non-constant step size.

As indicated in (4), through changing $R$ the electric circuit 100 is configured to alter the pulse width in constant steps by uniformly stepwise changing $R$ (e.g. using a configurable resistor ladder).

Thus, the electric circuit 100 may be implemented as so-called "supply-independent delay stage with constant delay step".

In case of the capacitor 122 having an adjustable capacitance $C$, the electric circuit 100 may be configured to vary a pulse width of the pulse width modulated output signal 106 as a function of the adjustable capacitance using a linear relationship between the adjustable capacitance and the pulse width.

In another example of the electric circuit 100 illustrated in Fig. 4, an output terminal of the operational amplifier 113 of the control loop 112' is "directly" connected to the gates of the MOSFETS 132 and 134.

A skilled person having benefit of the present disclosure will appreciate that compared to the example illustrated in Fig. 2 additional voltage headroom may be gained by "directly" connecting the operational amplifier 113 with the gates of the MOSFETS 132 and 134. Thus, a lower voltage signal 102 may be used for generating the pulse width modulated output signal 106.

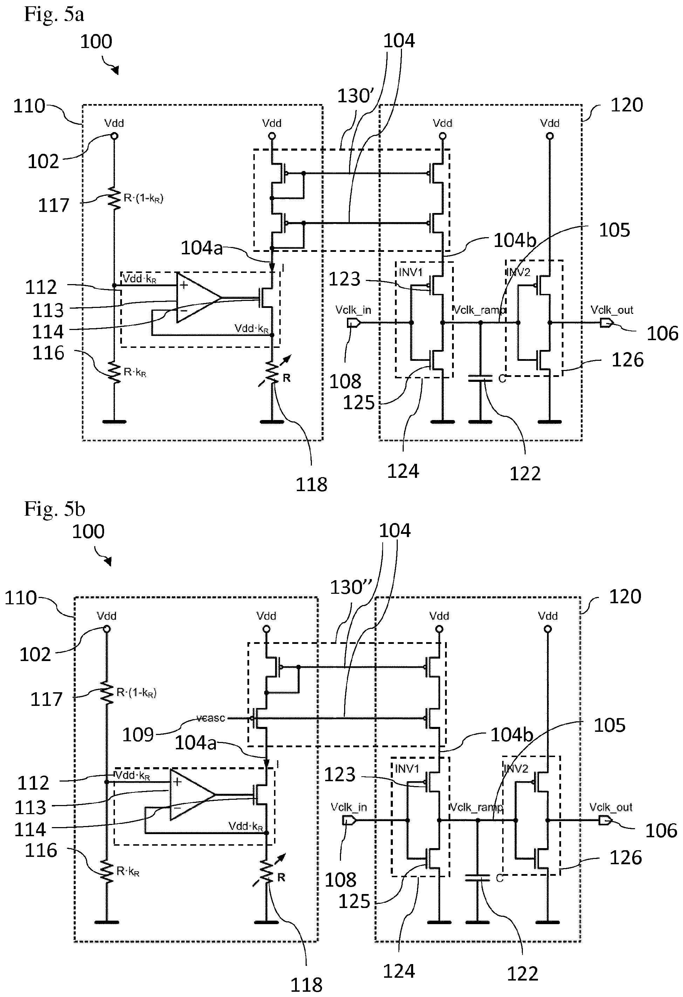

According to the invention, as shown in Fig. 5a, the "basic" current mirror 130 is replaced by a cascode current mirror 130'. The copied current signal 104b, which is copied using the "basic" current mirror 130, may derogate from the current signal 104a through the adjustable resistor 118, for example, due to a so-called channel length modulation effect of the current mirror 130. This effect may be reduced or almost be eliminated. Using the cascode current mirror 130' may improve an accuracy in copying the current signal 104a. The intermediate signal 104 may represent any or both of the gate connections in Figs. 5a and 5b.

An example of the electric circuit 100 illustrated in Fig. 5b comprises a "biased" cascode current mirror 130" which is biased with a cascode voltage $V_{casc}$ 109. Due to biasing the cascode current mirror 130" using the cascode voltage $V_{case}$, a minimum of the voltage signal 102 required for operating the "biased" cascode current mirror 130'' is be lowered with respect to the "basic" cascode current mirror 130'. Thus, the voltage signal $V_{dd}$ may be reduced, which may be desired with regard to some implementations of the electric circuit 100.

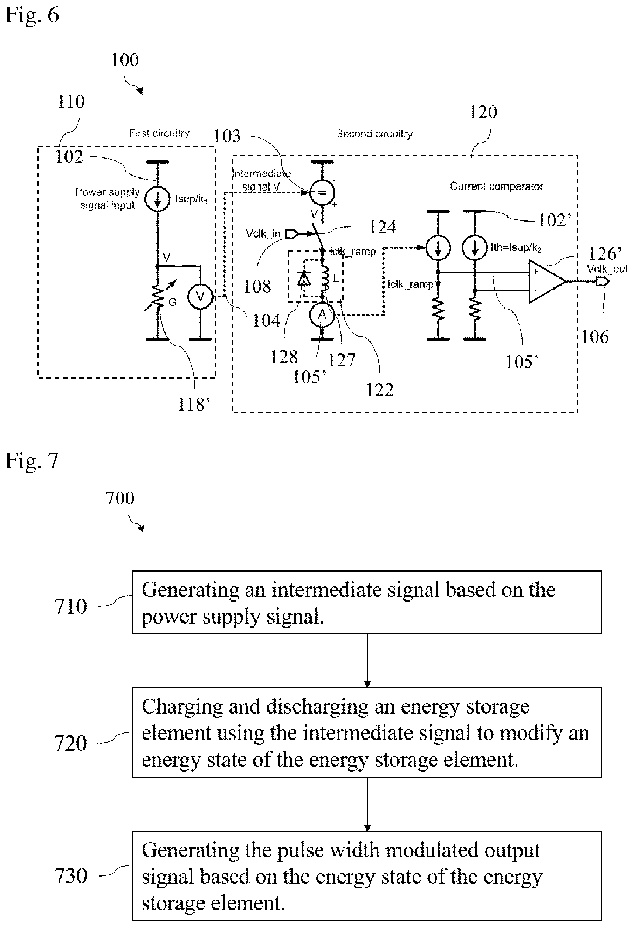

As illustrated in Fig. 6, the energy storage element 122 of the electric circuit 100 may comprise an inductor 127 and, in some examples, a diode 128 connected in parallel to the inductor 127 for generating the pulse width modulated output signal 106 in an equivalent manner as aforementioned examples of Fig. 2, 4, 5a and 5b.

The skilled person having benefit from the present disclosure will appreciate that the adjustable resistance 118 may be replaced by an adjustable conductance 118', the charging/discharging circuitry 124 may be implemented as a switch controlled by the clock signal 108 and the voltage comparator 126 may be replaced by a current comparator 126' to generate the pulse width modulated output signal in an equivalent manner as by using the aforementioned examples of the electric circuit 100.

Further, the power supply signal 102 may be a supply current signal. This may be forwarded to the adjustable conductance 118' for generating a voltage signal as the intermediate signal 104. The voltage signal 104 may be copied to a voltage source 103, for example, using an impedance converter as used in the examples of Fig. 2, 4, 5a and 5b. Thus, the inductor 127 may be charged with the voltage signal 104 based on the clock signal 108 controlling the switch for discharging or charging the inductor 127.

Thereby, a current 105' through the inductor 127 may increase. The skilled person is aware that the current 105' may be indicative of an energy state of the inductor 127.

For discharging the inductor 127, the switch 124 interrupts a connection between the inductor 127. Consequently, the current 105' flows off via the diode 128.

In order to control generating the pulse width modulated output signal 106, the current 105' may be provided to a current comparator 126' which, for example, comprises a operational amplifier in comparator configuration for comparing the current 105' with a threshold current 102'. The skilled person having benefit from the present disclosure will appreciate that the pulse width modulated output signal 106 may be generated analogously to the above-mentioned concepts based on a comparison of the current 105' and a threshold value 102'. The threshold value 102' may depend on the supply current 102.

Analogously to the aforementioned examples, the pulse width of the pulse width modulated output signal 106 may be modified in constant steps by uniformly stepwise altering an inductance of the inductor 127 and/or a conductance of the adjustable conductance 118'.

Further, an influence of the supply current 102 on the pulse width may be reduced due to the intermediate signal 104 and the threshold value 102' having at least partly compensating influences on the pulse width, as mentioned above in connection with the aforementioned examples.

The above-mentioned electric circuit 100 may be used in a control system (not illustrated) for a time-of-flight camera (TOF camera) (not illustrated) in order to adjust a pulsed light signal of a light source (not illustrated). For example, the same power supply signal 102 may be used. It is noted that the light source might not necessarily have to be supplied with the same power supply signal 102 as the electric circuit 100. In such applications, the light source may be coupled to another supply domain than an integrated circuit including the control circuit 100. For example, a brightness of the pulsed light signal may be varied as a function of the pulse width of the pulse width modulated output signal 106. The light source, for example, is a laser configured to provide visual or non-visual radiation in order to illuminate a scene which is monitored by the TOF camera.

As described above, influences of the power supply signal 102 on the pulse width modulated output signal 106 are reduced in examples, in some examples they may even be eliminated. Hence, for example, the brightness of the pulsed light signal is kept constant or at least variations are reduced despite varying the power supply signal 102.

Fig. 7 illustrates a method 700 for "reducing" an influence of a power supply signal on a pulse width modulated output signal, for example, using the aforementioned electric circuit 100. Method 700 comprises generating 710 an intermediate signal based on the power supply signal. For example, the intermediate signal may be generated by using a linear relationship between the power supply signal and by applying the power supply signal to an adjustable resistor or conductance.

The method 700 further comprises charging and discharging 720 an energy storage element using the intermediate signal to modify an energy state of the energy storage element. As mentioned above, the energy storage element is, for example, a capacitor or an inductor which, for example, may be charged and discharged using a charging/discharging circuitry.

Further, the method provides for generating 730 the pulse width modulated output signal based on the energy state of the energy storage element. A level/amplitude of the pulse width modulated output signal is adjusted depending on whether a condition defined for the energy state is fulfilled or unfulfilled. The condition is defined as fulfilled or unfulfilled depending on whether a measure of the energy state exceeds or falls short of a threshold value. Thus, the amplitude of the pulse width modulated output signal assumes two different levels. Hence, the pulse width modulated output signal is a binary signal.

More details and aspects of method 700 are explained in connection with the proposed technique or one or more examples described above. Method 700 may comprise one or more additional optional features corresponding to one or more aspects of the proposed technique or one or more examples described above.

The examples as described herein may be summarized as follows:

Some of the examples, according to the invention, relate to an electric circuit for generating a pulse width modulated output signal. The electric circuit comprises at least one power supply signal input and a first circuitry configured to generate and output an intermediate signal based on the power supply signal. Further, the electric circuit comprises a second circuitry configured to generate the pulse width modulated output signal based on the intermediate signal. The second circuitry comprises an energy storage element and a charging/discharging circuitry configured to charge and discharge the energy storage element using the intermediate signal to modify an energy state of the energy storage element. The second circuitry is configured to generate the pulse width modulated output signal based on the energy state of the energy storage element.

The power supply signal is a voltage signal and the intermediate signal is a current signal generated by applying at least a fraction of the voltage signal to an adjustable resistor.

The electric circuit further comprises a cascode current mirror configured to use the current signal as reference current and to copy and output the reference current to the second circuitry.

The pulse width modulated output signal is a binary signal changing amplitudes between a high level and a low level. The second circuitry is configured to change a level of the pulse width modulated output signal in response to a condition defined for the energy state of the energy storage element changing from being unfulfilled to being fulfilled.

The condition is defined so as to be fulfilled based on a comparison between the energy state of the energy storage element and a threshold value.

The second circuitry is configured to vary the threshold value as a function of the power supply signal.

According to some examples, the energy storage element comprises at least one capacitor, and wherein the energy state of the energy storage element is indicative of a voltage across the capacitor.

The description and drawings merely illustrate the principles of the disclosure. Furthermore, all examples recited herein are mainly intended expressly to be only for illustrative purposes to aid the reader in understanding the principles of the disclosure and the concepts contributed by the inventor(s) to furthering the art.

**Claims**

1. An electric circuit (100) configured to generate a pulse width modulated output signal (106), comprising:

   at least one power supply signal (102) input;
   first circuitry (110) configured to generate and output an intermediate signal (104) based on the power supply signal (102); and
   second circuitry (120) configured to generate the pulse width modulated output signal (106) based on the intermediate signal (104), the second circuitry (120) comprising an energy storage element (122) and a charging/discharging circuitry (124) configured to charge and discharge the energy storage element (122) using the intermediate signal (104) to modify an energy state of the energy storage element (122), the second circuitry (120) being configured to generate the pulse width modulated output signal (106) based on the energy state of the energy storage element (122),
   wherein the pulse width modulated output signal (106) is a binary signal changing amplitudes between a high level and a low level,
   wherein the second circuitry (120) is configured to change a level of the pulse width modulated output signal (106) in response to a condition defined for the energy state of the energy storage element (122) changing from being unfulfilled to being fulfilled,
   wherein the condition is defined so as to be fulfilled based on a comparison between the energy state of the energy storage element (122) and a threshold value (107),
   wherein the second circuitry (120) is configured to vary the threshold value (107) as a function of the power supply signal (102),
   **characterized in that** the power supply signal (102) is a voltage signal and the intermediate signal (104) is indicative of a current signal (104a) generated by applying at least a fraction of the voltage signal to an adjustable resistor (118) of the first circuitry (110), and
   wherein the electric circuit (100) further comprises a cascode current mirror (130', 130"), the cascode current mirror (130', 130") being configured to:

      use the current signal (104a) as reference current; and
      copy and output the reference current (104b) to the second circuitry (120).

2. The electric circuit (100) of one of the preceding claims, wherein the energy storage element (122) comprises at least one capacitor, and wherein the energy state of the energy storage element (122) is indicative of a voltage across the capacitor.

3. The electric circuit (100) of any one of the preceding claims, wherein the first circuitry (110) is configured to increase an amplitude of the intermediate signal (104) in response to an amplitude of the power supply signal (102) increasing, and the second circuitry (120) is configured to, in response to the amplitude of the power supply signal (102) increasing, modify the condition defined for the energy state of the energy storage element (122) to cause the condition to become fulfilled for an increased amount of energy stored in the energy storage element (122).

4. The electric circuit (100) of claims 2 and 3, wherein, in response to the amplitude of the power supply signal (102) increasing, the second circuitry (120) is configured to modify the threshold value (107) to cause the condition to become fulfilled for an increased amplitude of the voltage (105) across the capacitor.

5. The electric circuit (100) of one of the preceding claims, wherein the electric circuit (100) is configured to vary a pulse width of the pulse width modulated output signal (106) as a function of an adjustable resistance (118) using a linear relationship between the adjustable resistance (118) and the pulse width.

6. The electric circuit (100) of one of the preceding claims, wherein the electric circuit (100) is configured to vary a pulse width of the pulse width modulated output signal (106) as a function of an adjustable capacitance using a linear relationship between the adjustable capacitance and the pulse width.

7. A control system for a time-of-flight camera, comprising:

   an electric circuit (100) of any one of the claims 1 to 6 for generating a pulse width modulated output signal (106); and
   a light source for generating a pulsed light signal depending on the pulse width modulated output signal (106).

8. A method (700) for generating a pulse width modulated output signal (106) based on at least one power supply signal (102) input, comprising:

generating (710), by first circuitry (110), an intermediate signal (104) based on the power supply signal (102); charging and discharging (720), by charging/discharging circuitry of second circuitry (120), an energy storage element (122) of the second circuitry (120) using the intermediate signal (104) to modify an energy state of the energy storage element (122); and
generating (730), by the second circuitry (120), the pulse width modulated output signal (106) based on the energy state of the energy storage element (122),
wherein the pulse width modulated output signal (106) is a binary signal changing amplitudes between a high level and a low level, and
wherein the method (700) further comprises:

changing, by the second circuitry (120), a level of the pulse width modulated output signal (106) in response to a condition defined for the energy state of the energy storage element (122) being fulfilled, wherein the condition is defined so as to be fulfilled based on a comparison between the energy state of the energy storage element (122) and a threshold value (107) varying as a function of the power supply signal (102), **characterized in that** the power supply signal (102) is a voltage signal and the intermediate signal (104) is indicative of a current signal (104a) generated by applying at least a fraction of the voltage signal to an adjustable resistor (118) of the first circuitry (110), and
wherein the current signal (104a) is used as reference current for a cascode current mirror (130', 130"), the cascode current mirror (130', 130") copying and outputting the reference current (104b) to the second circuitry (120).

9. The method (700) of claim 8,

wherein an amplitude of the intermediate signal (104) increases in response to an amplitude of the power supply signal (102) increasing, and
wherein the method further comprises:
in response to the amplitude of the power supply signal (102) increasing, modifying the condition defined for the energy state of the energy storage element (122) to cause the condition to become fulfilled for an increased amount of energy stored in the energy storage element (122).

**Patentansprüche**

1. Elektrische Schaltung (100), die dazu ausgelegt ist, ein pulsbreitenmoduliertes Ausgangssignal (106) zu erzeugen, umfassend:

mindestens einen Eingang für ein Leistungsversorgungssignal (102);
eine erste Schaltungsanordnung (110), die dazu ausgelegt ist, ein Zwischensignal (104) basierend auf dem Leistungsversorgungssignal (102) zu erzeugen und auszugeben; und
eine zweite Schaltungsanordnung (120), die dazu ausgelegt ist, das pulsbreitenmodulierte Ausgangssignal (106) basierend auf dem Zwischensignal (104) zu erzeugen, wobei die zweite Schaltungsanordnung (120) ein Energiespeicherelement (122) und eine Lade-/Entladeschaltungsanordnung (124) umfasst, die dazu ausgelegt ist, das Energiespeicherelement (122) unter Verwendung des Zwischensignals (104) zu laden und zu entladen, um einen Energiezustand des Energiespeicherelements (122) zu modifizieren, wobei die zweite Schaltungsanordnung (120) dazu ausgelegt ist, das pulsbreitenmodulierte Ausgangssignal (106) basierend auf dem Energiezustand des Energiespeicherelements (122) zu erzeugen,
wobei das pulsbreitenmodulierte Ausgangssignal (106) ein binäres Signal ist, das Amplituden zwischen einem hohen Pegel und einem niedrigen Pegel ändert,
wobei die zweite Schaltungsanordnung (120) dazu ausgelegt ist, einen Pegel des pulsbreitenmodulierten Ausgangssignals (106) als Reaktion darauf zu ändern, dass sich eine für den Energiezustand des Energiespeicherelements (122) definierte Bedingung von nicht erfüllt zu erfüllt ändert,
wobei die Bedingung so definiert ist, dass sie basierend auf einem Vergleich zwischen dem Energiezustand des Energiespeicherelements (122) und einem Schwellenwert (107) erfüllt wird,
wobei die zweite Schaltungsanordnung (120) dazu ausgelegt ist, den Schwellenwert (107) als eine Funktion des Leistungsversorgungssignals (102) zu variieren,

**dadurch gekennzeichnet, dass**

das Leistungsversorgungssignal (102) ein Spannungssignal ist und das Zwischensignal (104) ein Stromsignal (104a) angibt, das durch Anlegen zumindest eines Bruchteils des Spannungssignals an einen einstellbaren Widerstand (118) der ersten Schaltungsanordnung (110) erzeugt wird, und wobei die elektrische Schaltung (100) ferner einen Kaskodenstromspiegel (130', 130") umfasst, wobei der Kaskodenstromspiegel (130', 130") zu Folgendem ausgelegt ist:

Verwenden des Stromsignals (104a) als Referenzstrom; und
Kopieren und Ausgeben des Referenzstroms (104b) an die zweite Schaltungsanordnung (120).

2. Elektrische Schaltung (100) nach einem der vorhergehenden Ansprüche, wobei das Energiespeicherelement (122) mindestens einen Kondensator umfasst, und wobei der Energiezustand des Energiespeicherelements (122) eine Spannung über den Kondensator angibt.

3. Elektrische Schaltung (100) nach einem der vorhergehenden Ansprüche, wobei die erste Schaltungsanordnung (110) dazu ausgelegt ist, eine Amplitude des Zwischensignals (104) als Reaktion darauf zu erhöhen, dass sich eine Amplitude des Leistungsversorgungssignals (102) erhöht, und die zweite Schaltungsanordnung (120) dazu ausgelegt ist, als Reaktion darauf, dass sich die Amplitude des Leistungsversorgungssignals (102) erhöht, die für den Energiezustand des Energiespeicherelements (122) definierte Bedingung zu modifizieren, um zu bewirken, dass die Bedingung für eine in dem Energiespeicherelement (122) gespeicherte erhöhte Energiemenge erfüllt wird.

4. Elektrische Schaltung (100) nach Anspruch 2 und 3, wobei die zweite Schaltungsanordnung (120) als Reaktion darauf, dass sich die Amplitude des Leistungsversorgungssignals (102) erhöht, dazu ausgelegt ist, den Schwellenwert (107) zu modifizieren, um zu bewirken, dass die Bedingung für eine erhöhte Amplitude der Spannung (105) über den Kondensator erfüllt wird.

5. Elektrische Schaltung (100) nach einem der vorhergehenden Ansprüche, wobei die elektrische Schaltung (100) dazu ausgelegt ist, eine Pulsbreite des pulsbreitenmodulierten Ausgangssignals (106) als eine Funktion eines einstellbaren Widerstands (118) unter Verwendung einer linearen Beziehung zwischen dem einstellbaren Widerstand (118) und der Pulsbreite zu variieren.

6. Elektrische Schaltung (100) nach einem der vorhergehenden Ansprüche, wobei die elektrische Schaltung (100) dazu ausgelegt ist, eine Pulsbreite des pulsbreitenmodulierten Ausgangssignals (106) als eine Funktion einer einstellbaren Kapazität unter Verwendung einer linearen Beziehung zwischen der einstellbaren Kapazität und der Pulsbreite zu variieren.

7. Steuersystem für eine Laufzeitkamera, umfassend:

eine elektrische Schaltung (100) nach einem der Ansprüche 1 bis 6 zum Erzeugen eines pulsbreitenmodulierten Ausgangssignals (106); und
eine Lichtquelle zum Erzeugen eines gepulsten Lichtsignals in Abhängigkeit von dem pulsbreitenmodulierten Ausgangssignal (106).

8. Verfahren (700) zum Erzeugen eines pulsbreitenmodulierten Ausgangssignals (106) basierend auf mindestens einem Eingang für ein Leistungsversorgungssignal (102), umfassend:

Erzeugen (710), durch eine erste Schaltungsanordnung (110), eines Zwischensignals (104) basierend auf dem Leistungsversorgungssignal (102);
Laden und Entladen (720), durch eine Lade-/Entladeschaltungsanordnung der zweiten Schaltungsanordnung (120), eines Energiespeicherelements (122) der zweiten Schaltungsanordnung (120) unter Verwendung des Zwischensignals (104), um einen Energiezustand des Energiespeicherelements (122) zu modifizieren; und
Erzeugen (730), durch die zweite Schaltungsanordnung (120), des pulsbreitenmodulierten Ausgangssignals (106) basierend auf dem Energiezustand des Energiespeicherelements (122),
wobei das pulsbreitenmodulierte Ausgangssignal (106) ein binäres Signal ist, das Amplituden zwischen einem hohen Pegel und einem niedrigen Pegel ändert, und
wobei das Verfahren (700) ferner Folgendes umfasst:

Ändern, durch die zweite Schaltungsanordnung (120), eines Pegels des pulsbreitenmodulierten Ausgangssignals (106) als Reaktion darauf, dass eine für den Energiezustand des Energiespeicherelements (122) definierte Bedingung erfüllt wird, wobei die Bedingung so definiert ist, dass sie basierend auf einem Vergleich zwischen dem Energiezustand des Energiespeicherelements (122) und einem Schwellenwert (107), der als eine Funktion des Leistungsversorgungssignals (102) variiert, erfüllt wird,

**dadurch gekennzeichnet, dass**

das Leistungsversorgungssignal (102) ein Spannungssignal ist und das Zwischensignal (104) ein Stromsignal (104a) angibt, das durch Anlegen zumindest eines Bruchteils des Spannungssignals an einen einstellbaren Widerstand (118) der ersten Schaltungsanordnung (110) erzeugt wird, und

wobei das Stromsignal (104a) als Referenzstrom für einen Kaskodenstromspiegel (130', 130") verwendet wird, wobei der Kaskodenstromspiegel (130', 130") den Referenzstrom (104b) kopiert und an die zweite Schaltungsanordnung (120) ausgibt.

9. Verfahren (700) nach Anspruch 8,

wobei sich eine Amplitude des Zwischensignals (104) als Reaktion darauf erhöht, dass sich eine Amplitude des Leistungsversorgungssignals (102) erhöht, und

wobei das Verfahren ferner Folgendes umfasst:

als Reaktion darauf, dass sich die Amplitude des Leistungsversorgungssignals (102) erhöht, Modifizieren der für den Energiezustand des Energiespeicherelements (122) definierten Bedingung, um zu bewirken, dass die Bedingung für eine in dem Energiespeicherelement (122) gespeicherte erhöhte Energiemenge erfüllt wird.

**Revendications**

1. Circuit électrique (100) configuré pour générer un signal de sortie modulé en largeur d'impulsion (106), comprenant :

au moins une entrée d'un signal d'alimentation (102) ;

une première circuiterie (110) configurée pour générer et délivrer un signal intermédiaire (104) sur la base du signal d'alimentation (102) ; et

une deuxième circuiterie (120) configurée pour générer le signal de sortie modulé en largeur d'impulsion (106) sur la base du signal intermédiaire (104), la deuxième circuiterie (120) comprenant un élément de stockage d'énergie (122) et une circuiterie de charge/décharge (124) configurée pour charger et décharger l'élément de stockage d'énergie (122) à l'aide du signal intermédiaire (104) afin de modifier un état d'énergie de l'élément de stockage d'énergie (122), la deuxième circuiterie (120) étant configurée pour générer le signal de sortie modulé en largeur d'impulsion (106) sur la base de l'état d'énergie de l'élément de stockage d'énergie (122),

le signal de sortie modulé en largeur d'impulsion (106) étant un signal binaire dont les amplitudes varient entre un niveau haut et un niveau bas,

la deuxième circuiterie (120) étant configurée pour modifier un niveau du signal de sortie modulé en largeur d'impulsion (106) dès lors qu'une condition définie pour l'état d'énergie de l'élément de stockage d'énergie (122) passe de non remplie à remplie,

la condition étant définie de manière à être remplie sur la base d'une comparaison entre l'état d'énergie de l'élément de stockage d'énergie (122) et une valeur seuil (107),

la deuxième circuiterie (120) étant configurée pour faire varier la valeur seuil (107) en fonction du signal d'alimentation (102),

**caractérisé en ce que**

le signal d'alimentation (102) est un signal de tension et le signal intermédiaire (104) indique un signal de courant (104a) généré par application d'au moins une fraction du signal de tension à une résistance ajustable (118) de la première circuiterie (110), et

le circuit électrique (100) comprenant en outre un miroir de courant en cascode (130', 130"), le miroir de courant en cascode (130', 130") étant configuré pour :

utiliser le signal de courant (104a) comme courant de référence ; et

copier et délivrer le courant de référence (104b) à la deuxième circuiterie (120).

2. Circuit électrique (100) selon l'une des revendications précédentes, dans lequel l'élément de stockage d'énergie (122) comprend au moins un condensateur, et dans lequel l'état d'énergie de l'élément de stockage d'énergie (122) indique une tension aux bornes du condensateur.

**3.** Circuit électrique (100) selon l'une quelconque des revendications précédentes, dans lequel la première circuiterie (110) est configurée pour accroître une amplitude du signal intermédiaire (104) en réponse à un accroissement d'une amplitude du signal d'alimentation (102), et la deuxième circuiterie (120) est configurée pour, en réponse à l'accroissement de l'amplitude du signal d'alimentation (102), modifier la condition définie pour l'état d'énergie de l'élément de stockage d'énergie (122) pour faire en sorte que la condition soit remplie pour une quantité accrue d'énergie stockée dans l'élément de stockage d'énergie (122).

**4.** Circuit électrique (100) selon les revendications 2 et 3, dans lequel, en réponse à l'accroissement de l'amplitude du signal d'alimentation (102), la deuxième circuiterie (120) est configurée pour modifier la valeur seuil (107) pour faire en sorte que la condition soit remplie pour une amplitude accrue de la tension (105) aux bornes du condensateur.

**5.** Circuit électrique (100) selon l'une des revendications précédentes, le circuit électrique (100) étant configuré pour faire varier une largeur d'impulsion du signal de sortie modulé en largeur d'impulsion (106) en fonction d'une résistance ajustable (118) à l'aide d'une relation linéaire entre la résistance ajustable (118) et la largeur d'impulsion.

**6.** Circuit électrique (100) selon l'une des revendications précédentes, le circuit électrique (100) étant configuré pour faire varier une largeur d'impulsion du signal de sortie modulé en largeur d'impulsion (106) en fonction d'une capacité ajustable à l'aide d'une relation linéaire entre la capacité ajustable et la largeur d'impulsion.

**7.** Système de commande pour une caméra à temps de vol, comprenant :

un circuit électrique (100) selon l'une quelconque des revendications 1 à 6 destiné à générer un signal de sortie modulé en largeur d'impulsion (106) ; et
une source lumineuse destinée à générer un signal de lumière pulsée en fonction du signal de sortie modulé en largeur d'impulsion (106).

**8.** Procédé (700) de génération d'un signal de sortie modulé en largeur d'impulsion (106) sur la base d'au moins une entrée d'un signal d'alimentation (102), comprenant :

la génération (710), par une première circuiterie (110), d'un signal intermédiaire (104) sur la base du signal d'alimentation (102) ;
la charge et la décharge (720), par une circuiterie de charge/décharge d'une deuxième circuiterie (120), d'un élément de stockage d'énergie (122) de la deuxième circuiterie (120) à l'aide du signal intermédiaire (104) afin de modifier un état d'énergie de l'élément de stockage d'énergie (122) ; et
la génération (730), par la deuxième circuiterie (120), du signal de sortie modulé en largeur d'impulsion (106) sur la base de l'état d'énergie de l'élément de stockage d'énergie (122),
le signal de sortie modulé en largeur d'impulsion (106) étant un signal binaire dont les amplitudes varient entre un niveau haut et un niveau bas, et
le procédé (700) comprenant en outre :

la modification, par la deuxième circuiterie (120), d'un niveau du signal de sortie modulé en largeur d'impulsion (106) dès lors qu'une condition définie pour l'état d'énergie de l'élément de stockage d'énergie (122) est remplie, la condition étant définie de manière à être remplie sur la base d'une comparaison entre l'état d'énergie de l'élément de stockage d'énergie (122) et une valeur seuil (107) variant en fonction du signal d'alimentation (102),
**caractérisé en ce que**
le signal d'alimentation (102) est un signal de tension et le signal intermédiaire (104) indique un signal de courant (104a) généré par application d'au moins une fraction du signal de tension à une résistance ajustable (118) de la première circuiterie (110), et
le signal de courant (104a) étant utilisé comme courant de référence pour un miroir de courant en cascode (130', 130"), le miroir de courant en cascode (130', 130") copiant et délivrant le courant de référence (104b) à la deuxième circuiterie (120).

**9.** Procédé (700) selon la revendication 8,

dans lequel une amplitude du signal intermédiaire (104) s'accroît en réponse à un accroissement d'une amplitude du signal d'alimentation (102), et
le procédé comprenant en outre :

en réponse à l'accroissement de l'amplitude du signal d'alimentation (102), la modification de la condition définie pour l'état d'énergie de l'élément de stockage d'énergie (122) pour faire en sorte que la condition soit remplie pour une quantité accrue d'énergie stockée dans l'élément de stockage d'énergie (122).

Fig. 1

Fig. 2

Fig. 3

Fig. 4

Fig. 5a

Fig. 5b

Fig. 6

Fig. 7

| 710 | Generating an intermediate signal based on the power supply signal. |
|---|---|
| 720 | Charging and discharging an energy storage element using the intermediate signal to modify an energy state of the energy storage element. |
| 730 | Generating the pulse width modulated output signal based on the energy state of the energy storage element. |

# EP 3 772 821 B1

REFERENCES CITED IN THE DESCRIPTION

**Patent documents cited in the description**

- US 2017302170 A1
- US 2009115535 A1

- US 5130582 A